# EUROPÄISCHE PATENTANMELDUNG

(11) **EP 1 315 173 A1**
(43) Veröffentlichungstag der Anmeldung: **28.05.2003**
(21) Anmeldenummer: 01127016.2
(22) Anmeldetag: 14.11.2001
(51) Int. Cl.: G11C 29/00

(54) **Testverfahren für ferroelektrische Speicher**

(71) Anmelder: aix ACCT Systems GmbH, 52068 Aachen (DE)
(72) Erfinder: Schmitz Thorsten, 51688 Wipperfürth (DE); Tiedke Stephan, 52379 Langerwehe (DE)
(74) Vertreter: Gille Hrabal Struck Neidlein Prop Roos

(57) **Zusammenfassung**

Die vorliegende Erfindung betrifft ein Verfahren zum Testen bzw. zur Ermittlung einer Charakteristik einer ferroelektrischen Spelcherzelle, welches sich alleine oder mit mehreren Speicherzellen auf einem Chip befindet sowie Chips, welche im oben genannten Verfahren Anwendung finden.

Das erfindungsgemäße Verfahren kann zur Überprüfung auf Funktionstüchtigkeit hergestellter Chips mit ferroelektrischen Speicherzellen und zur Prototypenentwicklung eingesetzt werden.

Im erfindungsgemäßen Verfahren werden in geschickter Weise Spannungen an die Leitungen des Chips angelegt, so dass der sich daraus ergebende Strom Rückschlüsse auf das Hysterese- und damit Speicherverhalten einer ferroelektrischen Speicherzelle ermöglicht.

Das erfindungsgemäße Verfahren ermöglicht somit einerseits den messtechnischen Zugang zu einer einzelnen Speicherzelle, andererseits kann ferner die Auswirkung der anderen Bauteile der Speicherzelle sowie des Layouts des gesamten Chips auf das Speicherverhalten einer einzelnen Speicherzelle ermittelt werden.

## Beschreibung

Die vorliegende Erfindung betrifft ein Verfahren zum Testen bzw. zur Ermittlung einer Charakteristik einer ferroelektrischen Speicherzelle, welches sich alleine oder mit mehreren Speicherzellen auf einem Chip befindet sowie Chips, welche im oben genannten Verfahren Anwendung finden.

In bekannten ferroelektrischen Chips zur Datenspeicherung (FRAM) werden ferroelektrische Polymere oder ferroelektrische Flüssigkeitskristalle, beispielsweise anorganische, keramikähnliche Verbindungen auf der Basis von Perovskit-Kristallstrukturen (insbesondere Blei-Zirkonium-Titanat oder niob-dotiertes Strontium-Wismut-Tantalat) verwendet.

Der Speichereffekt ferroelektrischen Speicherzellen beruht auf dem ferroelektrischen Effekt von Materialien, die ihren durch ein elektrisches Feld veränderbaren elektrischen Polarisationszustand auch nach dem Abklingen beibehalten und die den sogenannten ferroelektrischen Kondensator der ferroelektrischen Speicherzelle bilden.

Bekannte ferroelektrische Speicherzellen, welche sich auf einem Chip befinden, sind typischerweise in der sogenannten 1T1C-Anordnung verschaltet,

In Serie geschaltet sind ein ferroelektrischer Kondensator und ein Feldeffekttransistor. Eine Information wird als Polarisation auf dem ferroelektrischen Kondensator abgelegt, indem Spannungen an sämtlichen drei Leitungen angelegt wird, die aus der Serienschaltung von Kondensator und Transistor resultieren. Zum einen werden Spannungen an den zwei offenen Leitungen des Feldeffekttransistors angelegt, zum anderen an der verbleibenden offenen Leitung des ferroelektrischen Kondensators. Eine am Kondenstor anliegende Spannung schaltet den Transistor auf Durchgang und liegt als Steuerspannung am ferroelektrischen Kondensator an. Die darin enthaltenen molekularen elektrischen Dipole werden ausgerichtet, es kommt zur Polarisation. Da es sich um einen ferroelektrischen Kondensator handelt, verbleibt Polarisation - Remanenz - auf dem Kondensator, wenn die Spannung wieder auf Null zurückgefahren wird. Um nun eine gegenteilige Information auf dem ferroelektrischen Kondensator und damit auf der ferroelektrischen Speicherzelle abzulegen, also zum Beispiel von der einer entsprechenden Polarisation zugeordneten, digitalen "1"-Information auf die digitale "0"-Information zurückzuschalten, wird eine hinreichend große, umgekehrte Spannung angelegt. Die Polarisation verändert sprungartig ihre Ausrichtung; beispielsweise positive Polarisation zu negativer Polarisation oder umgekehrt.

Charakteristisch für das Verhalten, mit der die Polarisation eines ferroelektrischen Kondensators in Stärke und Vorzeichen auf die angelegte Spannung reagiert, ist die sogenannte Hysteresekurve. Bei einer Hysteresekurve wird Polarisation gegen Spannung aufgetragen. Erwünscht ist eine hohe, schlanke Kurve, da dann einerseits die Polarisationen sich hinreichend deutlich unterscheiden, um so die Information zuverlässig auszulesen. Ist die Kurve sehr schlank, so genügt eine geringe Spannung, um die Polarisation abzuändern. Informationen können dann besonders schnell auf der ferroelektrischen Speicherzelle und damit auf dem Chip abgelegt werden.

Nach dem Stand der Technik ist es bisher nur möglich, die Hysteresekurve unmittelbar am ferroelektrischen Kondensator zu ermitteln, insbesondere nur dann wenn der Schichtaufbau des Chips nicht abgeschlossen ist. Es ist unbekannt, eine Hysteresekurve, die sich aus der Gesamtheit der Bauteile einer ferroelektrischen Speicherzelle bzw. des Chips, also nach dem Abschluss des Schichtaufbaus des Chips, zu ermitteln.
Aufgabe der Erfindung ist die Schaffung eines Verfahrens, mit dem die Charakteristik einer ferroelektrischen Speicherzelle, die Bestandteil eines Chips ist, ermittelt werden kann.

Die Aufgabe der Erfindung wird durch ein Verfahren mit den Merkmalen des ersten Anspruchs gelöst. Vorteilhafte Ausgestaltungen ergeben sich aus den Unteransprüchen,

Eine ferroelektrische Speicherzelle mit einem ferroelektrischen Kondensator wird wenigstens über eine Bit-Line sowie eine Plate-Line angesteuert. Sind mehrere ferroelektrische Speicherzellen auf einem Chip angeordnet, gibt es im Allgemeinen entsprechend viele Bit- und Plate-Lines.

Beim erfindungsgemäßen Verfahren werden an eine Bit-Line der Speicherzelle eine Spannung angelegt und an eine Plate-Line der Speicherzelle eine Spannung angelegt, Die Spannungen sind in Höhe und zeitlichem Verlauf so gewählt, dass sich eine zeitlich variierende Potenzialdifferenz am ferroelektrischen Kondensator ergibt. Hierdurch gelingt es, den ferroelektrischen Kondensator definiert mit der Potenzialdifferenz zu stimulieren und so den Kondensator zu polarisieren, entpolarisieren sowie entgegengesetzt zu polarisieren. Ein sich hieraus resultierende Strom wird gemessen und als ein Maß für die Charakteristik verwendet.

Befindet sich eine ferrolelektrische Speicherzelle auf einem Chip, so ist es im Allgemeinen aufgrund des Schichtaufbaus und der Integration der Bauteile nicht möglich, den einzelnen ferroelektrischen Kondensator zu kontaktieren. Die Strukturen sind in der Regel zu klein, so dicht gepackt oder verdeckt, dass hier mit einer Nadel nicht kontaktiert werden kann. Die ferroelektrische Speicherzelle befindet sich ferner meist inmitten von vielen anderen Speicherzellen im Schichtaufbau des Chips. Daher ist ein Zugriff auf einen einzelnen ferroelektrischen Kondensator nicht möglich, um die Charakteristik einer einzelnen ferroelektrischen Speicherzelle in konventioneller Weise ermitteln zu können. Das erfindungsgemäße Verfahren ermöglicht den messtechnischen Zugriff auf einen einzelnen ferroelektrischen Kondensator einer ferroelektrischen Speicherzelle im Schichtaufbau eines Chips, Das erfindungsgemäße Verfahren kann zur Überprüfung auf Funktionstüchtigkeit hergestellter Chips mit ferroelektrischen Speicherzellen und zur Prototypenentwicklung eingesetzt werden

Da im Allgemeinen die Speicherzelle weitere elektronische Bauteile beispielsweise einen n-Kanal Feldeffekttransitstor aufweist, wird im erfindungsgemäßen Verfahren auch deren Einfluss auf die Charakteristik des ferroelektrischen Kondensators und damit der Speicherzelle erfasst.

Wird eine vorteilhafte Durchführungsvariante des erfindungsgemäßen Verfahrens auf eine ferromagnetische Speicherzelle mit einem Transistor angewendet, wird an eine Word-Line der Speicherzelle eine Spannung angelegt. Dabei ist die Spannung so gewählt, dass der Transistor durchschaltet. Einerseits kann ein Durchschalten des Transistors aufgrund der Verschaltung der Speicherzelle erforderlich sein, um den oben genannten resultierenden Strom zu ermöglichen. Andererseits beeinflusst der durchgeschaltete Transistor durch seinen Widerstand und / oder sein Schaltverhalten den resultierenden Strom, Die Charakteristik der Speicherzelle aus ferroelektrischem Kondensator und Transistor wird so erfasst.

In einer weiteren vorteilhaften Durchführungsvariante des erfindungsgemäßen Verfahrens sind Mittel zur Adressierung der Word-Line, beispielsweise ein Dekoder mit Adressleitungen, vorgesehen. Die Word-Line der Speicherzelle wird durch Adressierung ausgewählt. Insbesondere wenn sich mehrere Speicherzellen auf einem Chip befinden, ist so nicht erforderlich, jede einzelne Word-Line zu kontaktieren, um eine Spannung daran anzulegen. Damit wird vermieden, dass mechanische Kontaktierungspunkte, beispielsweise sogenannte "Pads", bereitgestellt werden müssen. Auf einem Chip ist kaum Platz vorhanden. Kontaktierungspunkte würden nachteilig den Platzbedarf erhöhen und wären beim Layout eines Chips nachteilig zu berücksichtigen.

In einer weiteren Durchführungsvariante der Erfindung weist das Verfahren einen Schritt auf, in dem an die Bit-Line der Speicherzelle eine in diesem Schritt zeitlich konstante Spannung angelegt wird. Die Spannung beträgt zum Beispiel 3,3 Volt. Die Höhe der Spannung hängt von der verwendeten Technologie beim Herstellungsprozess des Chip ab (beispielsweise bei 0,35 µm-Technologle 3,3 Volt, bei 0,18 µm-Technologie 1,5 Volt). Es wird insbesondere die Versorgungsspannung V_{DD} angelegt, die für den Betrieb der ferroelektrischen Speicherzelle erforderlich ist, Unter V_{DD} versteht der Fachmann die Abkürzung für die Versorgungsspannung.

Ferner wird in dem Schritt an die Plate-Line der Speicherzelle eine zeitlich wechselnde Spannung angelegt wird. Sie variiert typischerweise von 0 bis 3,3 Volt bzw, bis V_{DD}. Die variierende Spannung kann beispielsweise als Dreiecksspannung oder in Form eines Rechtecksignals angelegt werden. Sie variiert also zeitlich in der Form eines Dreiecks oder Rechtecks zwischen 0 und 3,3 Volt in einem Beispielsfall.

Die variierende und die konstante Spannung sind so gewählt, dass die Potenzialdifferenz am ferroelektrischen Kondensator innerhalb eines Bereiches zwischen 0 und beispielsweise 3,3 Volt variiert.

Die am Kondensator anliegende Potenzialdifferenz ergibt sich aus der Differenz der Spannungen, die an der Bit-Line und an der Plate-Line im jeweiligen Moment anliegt. Liegt also beispielsweise 3,3 Volt zu einem bestimmten Zeitpunkt an der Plate-Line an und ist an der Bit-Line 3,3 Volt angelegt worden, so liegt 0 Volt am ferroelektrischen Kondensator an. Liegt die Plate-Line im Beispielsfall auf 0 Volt, so ist die Potenzialdifferenz der anliegenden Spannungen 3,3 Volt. Es liegt dann eine Spannung von 3,3 Volt am ferroelektrischen Kondensator an.
Ferner weist die zuletzt genannte Durchführungsvariante der Erfindung einen weiteren Schritt auf, in dem die an der Bit-Line der Speicherzelle angelegte Spannung auf Null reduziert wird und In dem an die Plate-Line der Speicherzelle eine zeitlich wechselnde Spannung angelegt wird, wobei die Spannungen so gewählt sind, dass die Potenzialdifferenz am ferroelektrischen Kondensator innerhalb eines Bereiches variiert wird, der sich von Null zu einem Wert erstreckt, der sich im Vorzeichen vom vorgegebenen Wert unterscheidet. Beispielsweise wird kann die zeitlich wechselnde, an der Plate-Line anliegende Spannung dreiecksförmig zwischen 0 und 3,3 Volt variieren. Es resultiert hier eine Spannung zwischen 0 bis -3,3 Volt, die am ferroelektrischen Kondensator anliegt.

Beispielsweise kann vorgenannte Vorgehensweise notwendig sein, da aufgrund des Aufbaus des Transistors und/ oder der Verschaltung der Speicherzelle es ohne den Transistor zu zerstören nicht möglich ist, eine negative Spannung an die Plate-Line anzulegen.

Aufgrund der in beiden Abschnitten entgegengesetzten Potenzialdifferenzen ist es möglich, eine Charakteristik der Speicherzelle vollständig erfassen zu können. Die am ferroelektrischen Kondensator jeweilig anliegende Potenzialdifferenz bewirkt einen Stromfluss durch den ferroelektrischen Kondensator der Speicherzelle. Die Stärke des Stromes ist abhängig von der Spannung bzw. Potenzialdifferenz, die am Kondensator anliegt. Dieser Strom ist ein Maß für die Polarisation der ferroelektrischen Speicherzelle. Durch Anwendung der genannten Abschnitte wird die Hysteresekurve des ferroelektrischen Kondensators vollständig erfasst. Beispielsweise erreicht eine zeitliche Abfolge jeweils zweier dreiecksförmiger Spannungsverläufe der Plate-Line bei auf Spannung liegender Bit-Line und bei auf Null-Potenzial liegender Bit-Line somit das messtechnische Erfassen einer kompletten Hysteresekurve der jeweiligen ferroelektrischen Speicherzelle.

In einer vorteilhaften Ausgestaltung des Verfahrens wird in einem Zwischenschritt, welcher zwischen oben genannten Schritten vorgenommen wird, wie folgt vorgegangen. Zur Sicherstellung, dass am Kondensator während des Umstellens der Bit-Line von 0-Potenzial auf die konstante Spannung und umgekehrt kein Strom aufgrund einer eventuellen Potenzialdifferenz fließt, unterbricht ein Transistor, die Verbindung zwischen Plate- und Bit-Line. Insbesondere wird die Verbindung zwischen dem sogenannten "Storage Node" und der Bit-Line getrennt, da der Fachmann unter "Storage Node" den Berührpunkt zwischen Kondensator und Transistor versteht.
Insbesondere wird die Word-Line von einer Spannung auf 0-Potenzial geschaltet, Dadurch, dass während des Umschaltens der Bit-Line ein Stromfluss durch den ferroelektrischen Kondensator unterbunden wird, können keine das Messverfahren störenden Ströme auftreten, welche zu Missinterpretationen des Hystereseverhaltens bzw. der Charakteristik führen können.

In einer weiteren vorteilhaften Durchführungsvariante des Verfahrens wird in einem Zwischenschritt wie folgt vorgegangen. Zur Sicherstellung, dass keine Ströme verursachende Potenzialdifferenz am Kondensator während des Umstellens der Bit-Line von 0-Potenzial auf die konstante Spannung und umgekehrt anliegt, werden beide Spannungen so entsprechend zeitlich aufeinander abgestimmt geändert, dass die Potenzialdifferenz zwischen der an der Bit-Line und an der Plate-Line anliegenden Spannung 0 Volt ist. Durch diese vorteilhafte Ausgestaltung des Verfahrens gelingt es, ein Störsignal bei der Messung auszuschließen. Die Messung wird entsprechend verbessert. Eine solche Verfahrensweise ist insbesondere anzuwenden, wenn es aus technischen Gründen nicht möglich ist, einen Transistor sperrend zu schalten oder insbesondere die Word-Line während einer Messung ab- bzw. auf Null-Potenzial zuschalten.

In einer vorteilhaften Durchführungsvariante des Verfahrens wird eine Speicherzelle bereitgestellt, bei der zur Kontaktierung beispielsweise die Bit-Lines und Plate-Lines mit Pads versehen sind. Diese Pads bilden beispielsweise Kontaktflächen, welche auf mechanischem Wege durch Nadeln so kontaktiert werden können, dass die Kontaktimpedanz möglichst gering ist. Es gibt Speicherzellen, bei denen die Bit-Lines und Plate-Lines mit speziellen Verstärkern oder Treibern - bei den Bit-Lines die sogenannten "Sense Amplifiers" bzw. bei den Plate-Lines die sogenannten "Plate Line Drivers" oder "Cell Plate Drivers" - zur digitalen Normalisierung der Spannung verbunden sind, um grundsätzlich etwas über die Polung der Spannung aussagen zu können. Beim Verfahren ist es jedoch von Interesse, gezielt Spannungen anzulegen, bzw. resultierende Ströme messen zu können. Es ist daher erforderlich bei solcherart Speicherzellen, den Verstärker bzw. Treiber auszuschalten. Dies gelingt, indem die Pads - von der jeweiligen ferroelektrischen Speicherzelle aus gesehen - vor dem Verstärkereingang und dem Treiberausgang angebracht sind. Die Pads werden insbesondere im Herstellungsprozesses des Chips auf diesen aufgebracht.

Zur Durchführung des Verfahrens wird vorteilhaft ein Chip eingesetzt, bei dem Plate-Lines und Bit-Lines mit Pads versehen sind. Sie sind Bestandteil des Layouts des Chips.

In einer weiteren Ausgestaltung sind die Word-Lines ebenfalls mit Pads versehen,

Zur Durchführung des Verfahrens wird ferner vorteilhaft ein mit Pads versehener Chip eingesetzt, wobei die Dimensionierung der Pads so gewählt ist, dass sie mit der vorgenannten Nadel einzeln kontaktiert werden können. Die Dimensionierung und Lage der Pads ist so zu wählen, dass diese einzeln mit Nadeln kontaktiert werden können, beispielsweise durch mit "pico probes" bezeichnete Nadeln

Es gibt Chiptypen, bei denen es nicht vorgesehen ist, die Plate-Line einer ferroelektrischen Speicherzelle gezielt hochohmig schalten zu können. Ein hochohmig Schalten ist notwendig, damit die ein der Plate-Line eventuell vorgeschalteter Treiber beim Anlegen einer Spannung nicht zerstört werden kann.

Ist ein hochohmig Schalten so nicht möglich, muss am Chip im ausgeschalteten Zustand gemessen werden. Dazu werden in einer weiteren Ausgestaltung des erfindungsgemäßen Verfahrens bei einem solchen Chiptyp Pads auch für die Word-Lines bereitgestellt. Wiederum werden die Pads so angebracht, dass sie sich zwischen dem Transistor und einem dem Transistor möglicherweise vorgeschalteten elektrischen Treiber befinden. Der elektrische Treiber bewirkt, dass zwei diskrete, aber unterschiedliche Spannungszustände an der Word-Line anliegen, also zum Beispiel 0 oder 5 Volt, wenn die V_{DD}-Spannung 3,3 Volt wäre. Diese Spannungzustände auf der Word-Line müsssen nun von außen zugeführt werden.

Dieses Verfahren der letzt genannten Ausgestaltung wird bevorzugt an einem - von den an einer ferroelektrischen Speicherzelle zur Messung anliegenden Spannungen und Strömen abgesehenen - ansonsten stromlos geschalteten Chip durchgeführt.

Es wird die Word-Line kontaktiert, die unter anderem zu dem ausgewählten Speicherelement bzw. zum zugehörigen Transistor führt. An diese Word-Line wird eine Spannung angelegt. Diese Spannung beträgt typischerweise 5 Volt, wenn die V_{DD}-Spannung 3,3 Volt ist. Die Spannung ist so gewählt, dass der Transistor auf Durchgang geschaltet wird und zwar insbesondere im Bereich von 0 bis V_{DD}.

Um den Bulk Anschluss der Transistoren der jeweiligen Speicherzelle auf Masse zu legen, werden die entsprechenden Pads des Chips auf Masse gelegt. Der externe Pad-Ring des Chips wird auf Masse gelegt, um so den damit verbundenen Bulk-Anschluss des Transistors der ausgesuchten Speicherzelle auf Masse zu legen. Die Anlegung der Masse an den Bulk-Anschluss dient dazu, um eine definierte Potenzialdifferenz am Transistor zu erzeugen und so ein Durchschalten des Transistors bewirken zu können. Beim Verfahren der eingangs genannten Art liegt der Bulk-Anschluss bereits auf Masse, da der Chip aktiv betrieben wird.

Im Übrigen wird in der vorbeschriebenen Weise vorgegangen.

Nachteilig an letztgenannter Ausgestaltung des Verfahrens ist, dass sämtliche Word-Lines ebenfalls mit Pads zur Kontaktierung versehen werden müssen, um oben genannte nicht hochohmig schaltbare Chips verwenden zu können. Problematisch ist nicht die große Zahl an Pads sondern der fehlende räumliche Platz für die Pads.

Zur Vermeidung der zusätzlichen Pads mit den damit verbundenen Nachteilen wird verfahrensgemäß ein folgendermaßen abgewandelter Chip bereitgestellt.
Das Layout bzw. Design dieser Chips, bei denen designbedingt normalerweise Plate-Lines nicht hochohmig geschaltet werden können, ist dahingehend so verändert, dass entsprechende elektrische Treiber den ferroelektrischen Speicherzelle vorgeschaltet werden, die gegenüber den Speicherzellen hochohmig geschaltet werden können.

Ob eine Plate-Line hochohmig geschaltet werden kann, hängt von der Architektur der Plate-Line ab. Ist es aufgrund der Architektur der Plate-Lines nicht möglich, diese hochohmig zu schalten, so wird ein entsprechender elektrischer Treiber eingesetzt, der bewirkt, dass die Plate-Line hochohmig geschaltet werden kann.

In einer weiteren Durchführungsvariante des Verfahrens wird diese vorteilhaft an mehreren Speicherzellen gleichzeitig durchgeführt. Dazu werden die Speicherstellen in einer Ausführungsform parallel geschaltet.

Dadurch können vorteilhaft die Anzahl der erforderlichen Kontaktierungen, beispielsweise auch die erforderlichen Pads reduziert werden. Neben der Zeitersparnis, die sich bei der Messung der Charakteristik eines mit mehreren Speicherzellen versehenen Chips ergibt, kann dabei ferner vorteilhaft eine Rechteckspannnung als variierende Spannung verwendet werden. Da ansonsten an einer einzelnen Speicherzelle die zu messendenden Ladungsmengen zu gering sind, ergibt sich durch die Messung an mehreren Speicherzellen gleichzeitig eine ausreichend zu messende Ladung bei anliegender und variierender Rechteckspannung. Die gemessene Charakteristik kann so ausreichend genau gemessen werden und die Verwendung des Rechtecksignals bei der Messung der Charakteristik kommt der tatsächlichen Verwendung der Speicherzelle in der Speicheranwendung am nächsten und macht so die Charakteristik aussagekräftiger.

Neben der oben beschriebenen 1T-1C Zellen gibt es sogenannte "CHAIN FeRAM" Speicherzellen. Diese setzen sich aus einer Kette von parallel geschalteten Transistoren und ferroelektrischen Konensatoren zusammen. In Reihe zu dieser Kette ist ein sogenannter "Block-Select-Transistor" geschaltet. Wie üblich sperrt der n-Kanal MOS Transistor, wenn am Gate -Anschluss des Transistors 0 Volt anliegt. Um einen bestimmten der in Reihe liegenden ferroelektrischen Kondensatoren auszuwählen, wird der zu dem auszuwählenden Kondensator parallel liegende Transistor gesperrt, Alle anderen Transistoren der Kette werden in den leitenden Zustand geschaltet. Der "Block-Select-Transistor" wird in dieser Ausführungsform der Speicherzelle dazu benutzt, die leitende Verbindung zwischen Bit-Line und Plate-Line zu unterbrechen, wie es in einer Durchführungsvariante des erfindungsgemäßen Verfahrens erforderlich ist und oben bereits beschrieben wurde.

Nachstehend werden die folgenden Figuren beschrieben;
Figur 1 zeigt eine Hysteresekurve;
Figur 2 verdeutlicht die einzelnen Abschnitte der Hysterese;
Figur 3 ist eine Schnittansicht einer ferroelektrischen Speicherzelle;
Figur 4 ist die Schaltskizze einer ferroelektrischen Speicherzelle;
in Figur 5 sind die verfahrensmäßigen Verläufe der in der Speicherzelle anliegenden Spannungen sowie der Potentialdifferenzen in Abhängigkeit der Zeit dargestellt;
Figur 6 ist die Schaltskizze einer "CHAIN-FeRAM"-Speicherzelle.

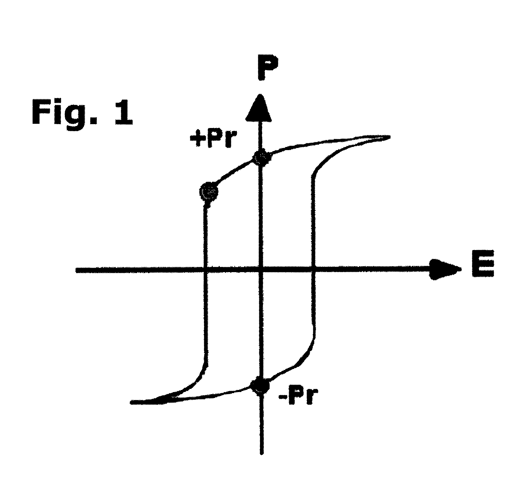

Figur 1 zeigt die Hysteresekurve eines ferroelektrischen Kondensators auf der die Datenspeicherung dieses Bauteils beruht. Die Punkte "+Pr" und "-Pr" markieren die remanente Polarisation nach dem Abschalten des Feldes. Diesen beiden gegensätzlichen Polarisationen lässt sich jeweils die digitale Information "0" oder "1" zuordnen.

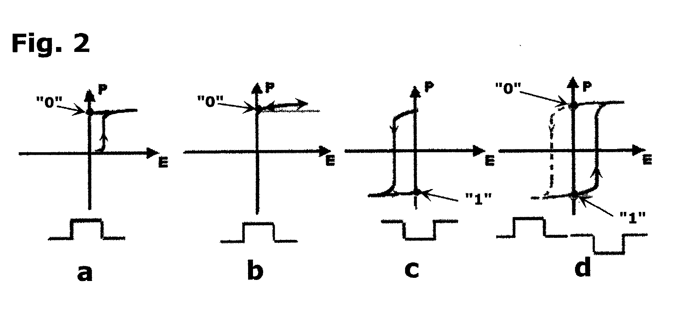

Figur 2 zeigt einzelne Abschnitte der Hysteresekurve. Darin wird verdeutlicht wie die Eigenschaft des ferroelektrischen Kondensators und der damit verbundenen Hysterese genutzt wird, um die den remanenten Polarisationen zugeordneten digitalen Zustände in den Kondensator zu schreiben bzw. auszulesen. Die einzelnen Verläufe der Hystereskurve werden durch das erfindungsgemäße Verfahren ausgemessen.

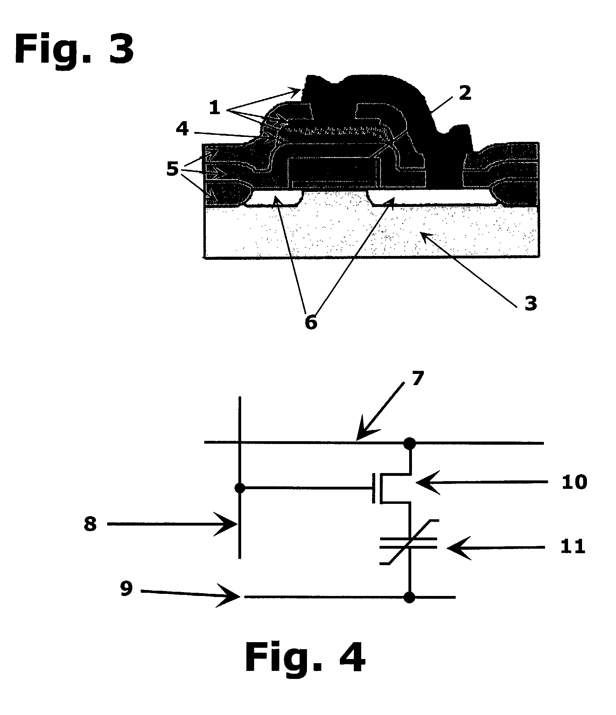

Figur 3 zeigt den Schichtaufbau einer ferroelektrischen Speicherzelle, wie sie sich auf einem Chip befindet. Mit Metallelektroden 1 ist dabei das Ferroelektrikum 4 des ferroelektrischen Kondensators kontaktiert. Unterhalb des ferroelektrischen Kondensators befindet sich der n-Kanal Feldeffekttransistor, der aus Poly-Silizium 2, dem p-dotierten Silizium 3 und dem n-dotierten Kanälen 6 gebildet wird. Die einzelnen Elemente sind in Schichten von Siliziumoxid 5 eingebettet.

Figur 4 zeigt die elektrische Verschaltung innerhalb einer ferroelektrischen Speicherzelle, Die Word-Line 8 ist mit dem Gate-Anschluss des Transistors 10 verbunden, Der Drain-Anschluss des Transistors 10 ist mit der Bit-Line 7 verbunden. Am Source-Anschluss ist der ferroelektrische Kondensator 11 angeschlossen. Dieser wiederum ist an der Plate-Line 9 angeschlossen.

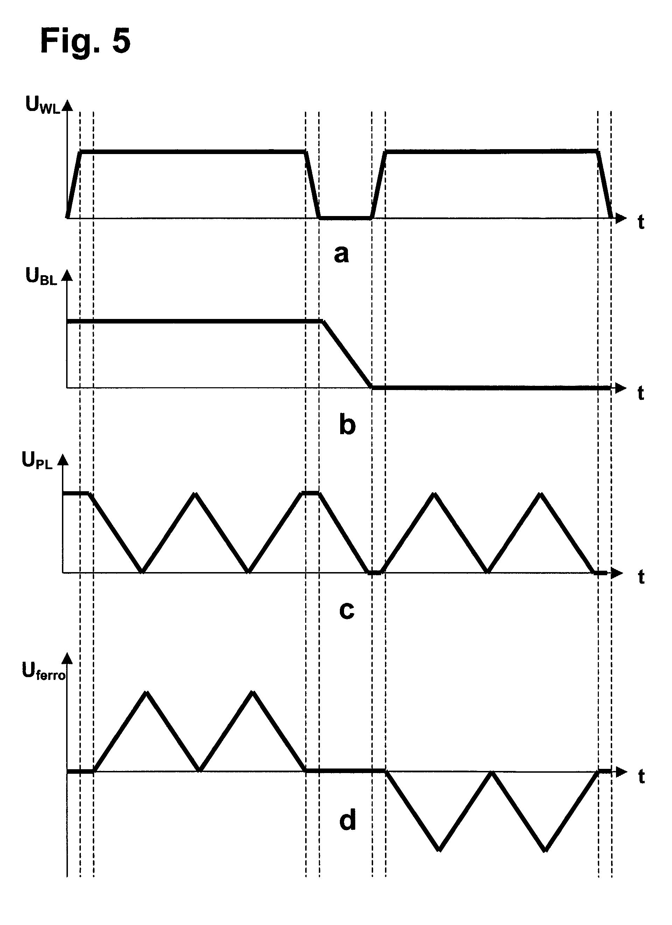

In Figur 5 sind die zeitabhängigen Verläufe der im Verfahren anliegenden Spannungen bzw. Potentialdifferenzen gezeigt. Figur 5 a zeigt den Verlauf der an der Word-Line anliegenden Spannung, Im Vergleich dazu zeigt Figur 5 b den Spannungsverlauf der an der Bit-Line anliegenden Spannung. Ferner zeigt Figur 5 c den dazu ebenso zeitlich parallelen Verlauf der an der Plate-Line anliegenden Spannung. In Figur 5 d ist der sich aus den in den Figuren 5 b und 5 c gezeigten Spannungsverläufen ergebende Verlauf der Potenzialdifferenz gezeigt, welche am ferroelektrischen Kondensator wirkt. Der sich aus dieser Potenzialdifferenz ergebende Stromverlauf wird im Verfahren gemessen.

Im Spannungsverlauf der Figur 5 a ist gemäß einer Ausführungsform des erfindungsgemäßen Verfahrens die an der Word-Line anliegende Spannung gerade dann auf Null reduziert, wenn die an der Bit-Line anliegende Spannung eine Veränderung erfährt.

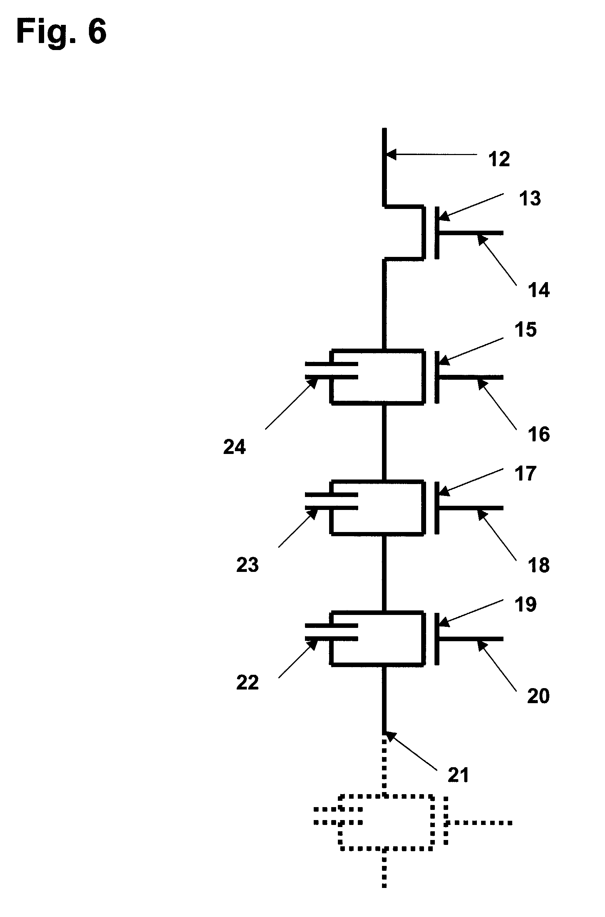

Figur 6 zeigt den Schaltplan einer "CHAIN-FeRAM"-Speicherzelle. Diese weist mehrere Transistoren 13, 15, 17, 19 und ferroelektrische Kondensatoren 22, 23, 24 sowie zugehörige Word-Lines 16, 18, 20 auf. Dabei treten kettenartig die parallelgeschalteten Elemente aus ferroelektrischem Kondensator und zugehörigem Transistor mehrfach auf, wie durch das gestrichelt eingezeichnete Element verdeutlicht wird. Typischerweise liegen diese 8-, 16- und 32-fach in der Schaltung vor. Am jeweilig letzten Element liegt die Plate-Line 21 an. Der Block-Select-Transistor 13 wird bei Anwendung des erfindungsgemäßen Verfahrens mit Hilfe der Leitung 14 auf Sperren geschaltet und unterbricht so die Verbindung zwischen Bit-Line 12 und der Plate-Line 21. Um einen bestimmten der in Reihe liegenden ferroelektrischen Kondensatoren 22, 23 oder 24 auszuwählen, wird der zu dem auszuwählenden ferroelektrischen Kondensator parallel liegende Transistor 15, 17 oder 19 gesperrt. Alle anderen Transistoren der Kette sind dabei mit Hilfe der entsprechenden Word-Line 16, 18 oder 20 in leitendem Zustand geschaltet.

## Patentansprüche

1. Messverfahren zur Ermittlung der Charakteristik einer Speicherzelle mit einem ferroelektrischen Kondensator,
bei dem an eine Bit-Line der Speicherzelle eine Spannung angelegt wird und bei dem an eine Plate-Line der Speicherzelle eine Spannung angelegt wird, wobei die Spannungen so gewählt sind, dass sich eine zeitlich variierende Potenzialdifferenz am ferroelektrischen Kondensator ergibt und ein hieraus resultierender Strom gemessen und als ein Maß für die Charakteristik verwendet wird.

2. Messverfahren nach dem vorhergehenden Anspruch,
wobei die Speicherzelle einen Transistor aufweist und
bei dem Verfahren an eine Word-Line der Speicherzelle eine Spannung angelegt wird, wobei die Spannung so gewählt wird, dass der Transistor durchschaltet.

3. Messverfahren nach dem vorhergehenden Anspruch,
wobei Mittel zur Adressierung der Word-Line der Speicherzelle vorgesehen sind, und die Wordline der Speicherzelle durch Adressierung ausgewählt wird.

4. Messverfahren nach einem der vorhergehenden Ansprüche,
bei dem in einem Schritt an die Bit-Line der Speicherzelle eine konstante Spannung angelegt wird und in dem an die Plate-Line der Speicherzelle eine zeitlich wechselnde Spannung angelegt wird, wobei die Spannungen so gewählt sind, dass die Potenzialdifferenz am ferroelektrischen Kondensator innerhalb eines Bereiches zwischen 0 und einem vorgegebenen Wert variiert, und
bei dem in einem weiteren Schritt die an der Bit-Line der Speicherzelle angelegte Spannung auf Null reduziert wird und in dem an die Plate-Line der Speicherzelle eine zeitlich wechselnde Spannung angelegt wird, wobei die Spannungen so gewählt sind, dass die Potenzialdifferenz am ferroelektrischen Kondensator innerhalb eines Bereiches zwischen 0 und Wert variiert, der sich im Vorzeichen vom vorgegebenen Wert unterscheidet.

5. Messverfahren nach dem vorhergehenden Anspruch, welches eines weiteren Schritt aufweist, welcher zwischen den vorgenannten Schritten vorgenommenen wird und bei dem ein Transistor eine Verbindung zwischen Plate-Line und Bit-Line sperrend schaltet, insbesondere, indem eine an die Word-Line anliegende Spannung auf Null reduziert wird.

6. Messverfahren nach einer der beiden vorhergehenden Ansprüche, welches einen weiteren Schritt aufweist, welcher zwischen den vorgenannten Schritten vorgenommenen wird und in dem die an der Plate-Line und der Bit-Line der Speicherzelle anliegenden Spannung so verändert werden, dass die Spannungen am Kondensator Null beträgt.

7. Messverfahren nach einem der vorhergehenden Ansprüche, wobei eine zur Kontaktierung mit einem oder mehreren Pads versehene Speicherzelle verwendet wird.

8. Messverfahren nach einem der vorhergehenden Ansprüche, wobei das Verfahren an mehreren Speicherzellen gleichzeitig durchgeführt wird.

9. Chip zur Durchführung des Messverfahrens nach einem der vorhergehenden Ansprüche, in dem die Bit-Lines und Plate-Lines mit einem Pad zur Kontaktierung versehen sind.

10. Chip zur Durchführung des Messverfahrens nach einem der Ansprüche 1 bis 7, welcher mit einem oder mehrerer Pads zur Kontaktierung versehen sind, wobei diese zur Nadelkontaktierung angeordnet und dimensioniert ist.
